# EUROPEAN PATENT SPECIFICATION

(11) **EP 2 983 204 B1**
(45) Date of publication and mention of the grant of the patent: **26.02.2020**
(21) Application number: 15173524.8
(22) Date of filing: 24.06.2015
(51) Int. Cl.: H01L 27/12, H01L 29/66, H01L 29/786, H01L 27/32, H01L 29/24

(54) **DISPLAY DEVICE AND METHOD FOR MANUFACTURING THE SAME**
ANZEIGEVORRICHTUNG UND VERFAHREN ZU DEREN HERSTELLUNG
DISPOSITIF D'AFFICHAGE ET SON PROCEDE DE FABRICATION

(30) Priority: 06.08.2014 KR 20140101325
(43) Date of publication of application: 10.02.2016
(73) Proprietor: LG Display Co., Ltd., SEOUL, 07336 (KR)
(72) Inventor: WOO, Changseung, 412-020 Goyang-si, Gyeonggi-do (KR); HONG, Soonhwan, 122-802 Seoul (KR)
(74) Representative: Ter Meer Steinmeister & Partner

(56) References cited:
- EP-A2- 2 657 969
- US-A1- 2011 127 531
- US-A1- 2013 126 876
- US-A1- 2014 138 714
- US-A1- 2014 145 195
- US-A1- 2014 159 059

## Description

### BACKGROUND OF THE INVENTION

### Field of the Invention

Embodiments of the invention relate to a display device including an oxide semiconductor thin film transistor (TFT) and a method for manufacturing the same.

### Discussion of the Related Art

A display device includes a thin film transistor (TFT) at each pixel so as to turn on a data voltage applied to the pixel or drive the pixel. An amorphous silicon TFT, polycrystalline silicon TFT, an oxide TFT, etc, are known as the TFT.

The oxide TFT has mobility greater than the amorphous silicon TFT and can be manufactured in a low temperature process. Further, the oxide TFT has an advantage of transparency capable of transmitting visible light. Thus, the oxide TFT is suitable for a high resolution display device or a transparent display device.

An oxide semiconductor dissolves easily in an acid solution. Thus, when a metal stacked on the oxide semiconductor is wet etched, the oxide semiconductor may be lost by an etchant. The metal stacked on the oxide semiconductor may be dry etched. However, a damage to the surface of the oxide semiconductor may be generated by plasma generated for the dry etching.

An etch stopper is formed on the oxide semiconductor, so as to prevent the back etching of the oxide semiconductor. However, a photomask process for forming the etch stopper has to be added. The photomask process is a photolithography process technology for sequentially performing a series of processes including a thin film deposition process, a photoresist application process, a photomask alignment process, an exposure process, a development process, an etching process, a strip process, etc., and patterning a thin film in a desired pattern. A reduction in the number of photomask processes may result in a reduction in the manufacturing cost and an increase in the yield.

A gate insulator is formed of silicon oxide (SiOx), so as to prevent changes in characteristics of the oxide TFT. It takes more time to perform a wet etching process and a dry etching process of silicon oxide (SiOx) than silicon nitride (SiNx) which was widely used as a material of an existing gate insulator. A method for simultaneously etching the etch stopper and the gate insulator, each of which is formed of silicon oxide (SiOx), through the dry etching process may be considered. However, because it is highly likely that a photoresist pattern is lost due to a long process time, it is difficult to adopt the method. Thus, a separate photomask process for patterning the gate insulator formed of silicon oxide (SiOx) is added.

A common voltage Vcom may be supplied to the pixels through a gate metal. In this instance, the gate metal has to be exposed by etching the gate insulator covering the gate metal. When the gate insulator is formed of silicon oxide (SiOx), the gate insulator is etched through the separate photomask process.

A passivation layer covering the oxide TFT may use an organic passivation layer. The organic passivation layer may be formed of photoacryl. A pixel electrode may be connected to a source of the oxide TFT by etching a portion of the passivation layer at a position outside the oxide TFT. However, this method has to form a hole for exposing the pixel electrode to the organic passivation layer in an opening inside the pixel. Therefore, an additional margin for forming the hole in the opening is necessary. The additional margin leads to a reduction in an aperture ratio of the pixel.

US 2013/0126876 A1 relates to an array substrate for a fringe field switching (FFS) mode liquid crystal display device and a method for fabricating the same. The liquid crystal display device may include a gate line formed on the substrate; a data line crossed with the gate line to define a pixel region; a thin-film transistor (TFT) formed at an intersection of the gate and data line; an organic insulating layer formed to have an opening portion for exposing the TFT; a common electrode having an area formed at an upper portion of the organic insulating layer, and an auxiliary electrode pattern connected to the TFT through the opening portion; a passivation layer formed to expose the auxiliary electrode pattern connected to the TFT; and pixel electrodes electrically connected to the TFT through the exposed auxiliary electrode pattern.

US 2011/0127531 A1 relates to a display device, a thin-film transistor (TFT) substrate, and a method of fabricating the TFT substrate. The method includes: forming a gate electrode on a pixel region of a substrate; forming a gate insulating film on the gate electrode; forming a semiconductor layer on the gate insulating film to overlap the gate electrode; forming a source electrode and a drain electrode to overlap the semiconductor layer and thus form a channel region; and forming a data insulating film on the source electrode and the drain electrode and patterning the data insulating film such that part of a contact hole formed in the data insulating film overlaps the channel region.

### SUMMARY OF THE INVENTION

Embodiments of the invention provide a display device as defined in claim 1 and a method for manufacturing the same capable of reducing the number of manufacturing processes and increasing an aperture ratio of a pixel as defined in claim 6.

In one aspect, there is a display device comprising a thin film transistor (TFT) including a gate connected to a gate line, a drain connected to a data line, and a source connected to a pixel electrode, and a passivation layer pattern formed in an opening excluding the TFT from a pixel area.

The pixel electrode directly contacts the source of the TFT on the gate of the TFT or the gate line.

In another aspect, there is a display device comprising a first metal pattern including a gate line, a gate of a thin film transistor (TFT) connected to the gate line, and a contact electrode; a gate insulator configured to cover the gate of the TFT and the gate line and expose the contact electrode; a second metal pattern including a data line, a drain of the TFT connected to the data line, and a source of the TFT, the second metal pattern disposed on the gate insulator; a passivation layer pattern including a first inorganic passivation layer disposed on a portion of the second metal pattern and the gate insulator and an organic passivation layer disposed on the first inorganic passivation layer; a first oxide semiconductor pattern disposed in a channel region of the TFT, the first oxide semiconductor pattern configured to contact the data line and the source and the drain of the TFT; a second oxide semiconductor pattern configured to contact the contact electrode; a second inorganic insulator including an insulating pattern covering a portion of the first oxide semiconductor pattern and an insulating pattern covering a portion of the second oxide semiconductor pattern; and a pixel electrode configured to overlap the second oxide semiconductor pattern on the second inorganic insulator.

In yet another aspect, there is a method for manufacturing a display device comprising a first photomask process for forming a gate line, a gate of a thin film transistor (TFT), and a contact electrode on a substrate and forming a gate insulator covering the gate line, the gate of the TFT, and the contact electrode on the substrate; a second photomask process for exposing a data line on the gate insulator and a source of the TFT to the contact electrode of a gate metal pattern using a halftone mask; a third photomask process for forming a passivation layer pattern, in which an inorganic passivation layer and an organic passivation layer are stacked, in an opening excluding the TFT from a pixel; a fourth photomask process for forming an oxide semiconductor pattern in a channel region and a source-drain area of the TFT and the opening of the pixel, covering the TFT and the contact electrode with a photoresist, performing a plasma processing on the exposed oxide semiconductor pattern to metalize the oxide semiconductor pattern, and forming a common electrode; a fifth photomask process for forming an etch stopper covering the oxide semiconductor pattern and the common electrode in the channel region of the TFT and performing the plasma processing to metalize an oxide semiconductor pattern formed in the source-drain area of the TFT and an oxide semiconductor pattern between the common electrode and the contact electrode; and a sixth photomask process for forming a pixel electrode directly contacting the source of the TFT on the gate of the TFT or the gate line.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIG. 1 is a plane view showing a pixel of a display device according to an exemplary embodiment of the invention;
FIGS. 2A to 7B illustrate a method for manufacturing a pixel shown in FIG. 1;
FIGS. 8A to 8E are cross-sectional views showing in stages a second photomask process; and
FIG. 9 shows an improvement effect of an aperture ratio of a display device according to an exemplary embodiment of the invention.

### DETAILED DESCRIPTION OF THE EMBODIMENTS

Reference will now be made in detail to embodiments of the invention, examples of which are illustrated in the accompanying drawings. Wherever possible, the same reference numbers will be used throughout the drawings to refer to the same or like parts. It will be paid attention that detailed description of known arts will be omitted if it is determined that the arts can mislead the embodiments of the invention.

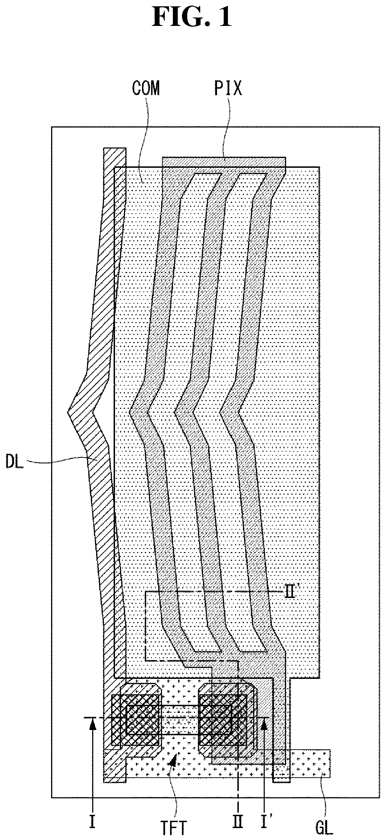

Referring to FIG. 1, a pixel of a display device according to an exemplary embodiment of the invention includes data lines DL, gate lines GL crossing the data lines DL, a thin film transistor (TFT) formed at a crossing of the data lines DL and the gate lines GL, a pixel electrode PIX connected to the TFT, a common electrode COM to which a common voltage Vcom is supplied, and the like. In the embodiment disclosed herein, the TFT is an oxide TFT.

The TFT is exposed through a hole formed in an organic passivation layer. The organic passivation layer is formed in a portion excluding the TFT from the pixel. An insulating pattern serving as an etch stopper is formed in a channel region of the TFT. A source of the TFT and the pixel electrode PIX directly contact each other on a gate of the TFT or the gate line GL. Thus, a wide margin of the hole of the organic passivation layer does not need to be secured. Hence, an aperture ratio of the pixel increases, and a contact resistance deceases through an increase in a contact area between the TFT and the pixel electrode PIX.

The embodiment of the invention simultaneously patterns a source-drain metal and a gate insulator GI and simultaneously forms the channel region of the oxide TFT and the common electrode COM, so as to reduce the number of manufacturing processes of the display device. Thus, the embodiment of the invention may omit at least three photomask processes, compared to a related art.

The common electrode COM receives the common voltage Vcom through a contact electrode GM. Thus, a deviation of the common voltage Vcom of the pixels throughout the entire screen of the display device is reduced. The contact electrode GM is formed of the same gate metal as the gate of the TFT and the gate line GL and is positioned on the same level layer as a gate metal pattern. The common electrode COM includes a metalized oxide semiconductor and contacts the contact electrode GM through a contact hole passing through a passivation layer pattern.

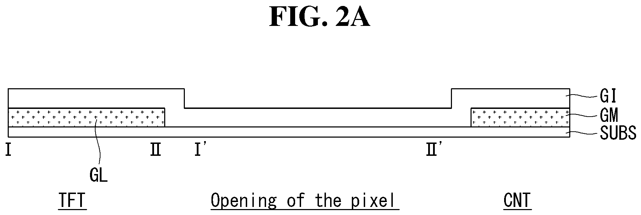

FIGS. 2A to 7B illustrate a method for manufacturing the pixel shown in FIG. 1. More specifically, FIGS. 2A to 7B show cross sections of the TFT, an opening PIXEL of the pixel, and a common electrode contact part CNT taken along lines I-I' and II-II' of FIG. 1. The common electrode contact part CNT may be formed outside a pixel array of a display panel, i.e., in an outer area of the display panel. In this instance, the common electrode contact part CNT is not seen in the pixel shown in FIG. 1.

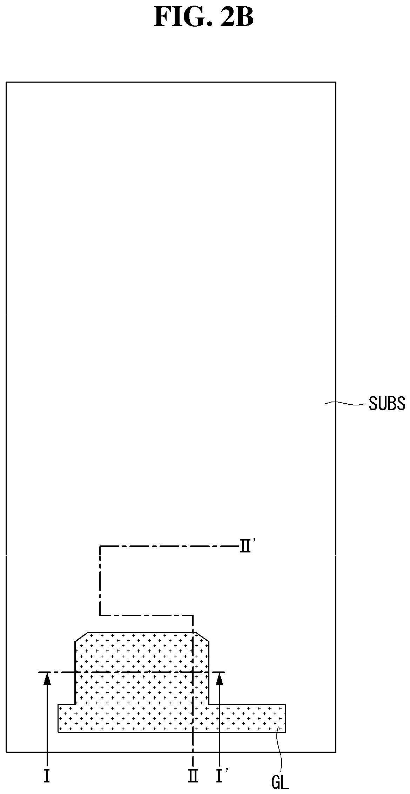

A first photomask process is described with reference to FIGS. 2A and 2B.

Referring to FIGS. 2A and 2B, a gate metal is deposited on a substrate SUBS and is partially etched through the first photomask process. As a result of the first photomask process, a gate metal pattern is formed on the substrate SUBS. In a subsequent etching process for etching a source-drain metal, the gate metal has to be selected as a metal, which is not etched by an etchant used in the etching process. When the source-drain metal is formed of copper (Cu), the gate metal is selected as a metal, for example, molybdenum (Mo) and molybdenum titanium (MoTi), which is not etched by a Cu etchant. The gate metal pattern includes the gate of the TFT, the gate line GL, and the contact electrode GM. The gate of the TFT may be integrated with the gate line GL. Subsequently, a gate insulator GI is deposited. The gate insulator GI covers the gate metal pattern. The gate insulator GI may be formed of silicon oxide (SiOx). The contact electrode GM contacts the common electrode COM and supplies the common voltage Vcom to the common electrode COM.

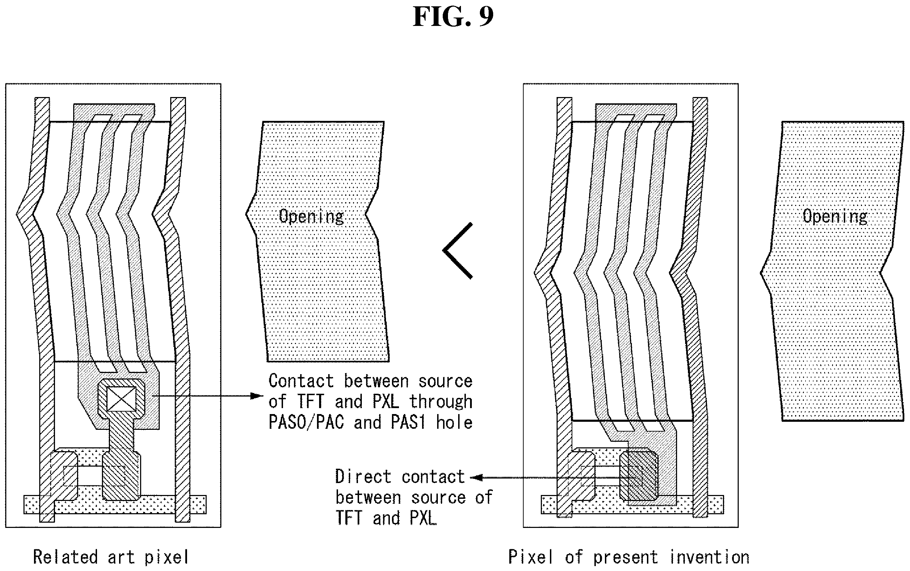

The TFT according to the embodiment of the invention is formed on the gate line GL. A contact portion between the source of the TFT and the pixel electrode is positioned on the gate of the TFT or the gate line GL. Thus, the aperture ratio of the pixel according to the embodiment of the invention increases compared to the related art (refer to the left drawing of FIG. 9), in which a contact portion between the source of the TFT and the pixel electrode is separated from the gate line GL.

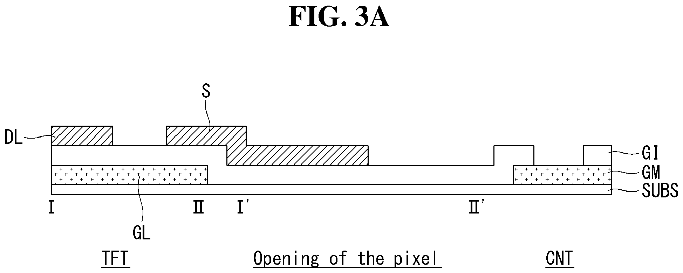

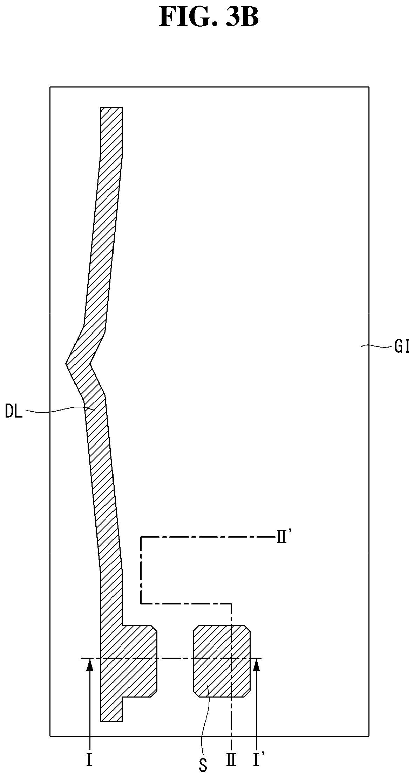

A second photomask process is described with reference to FIGS. 3A and 3B.

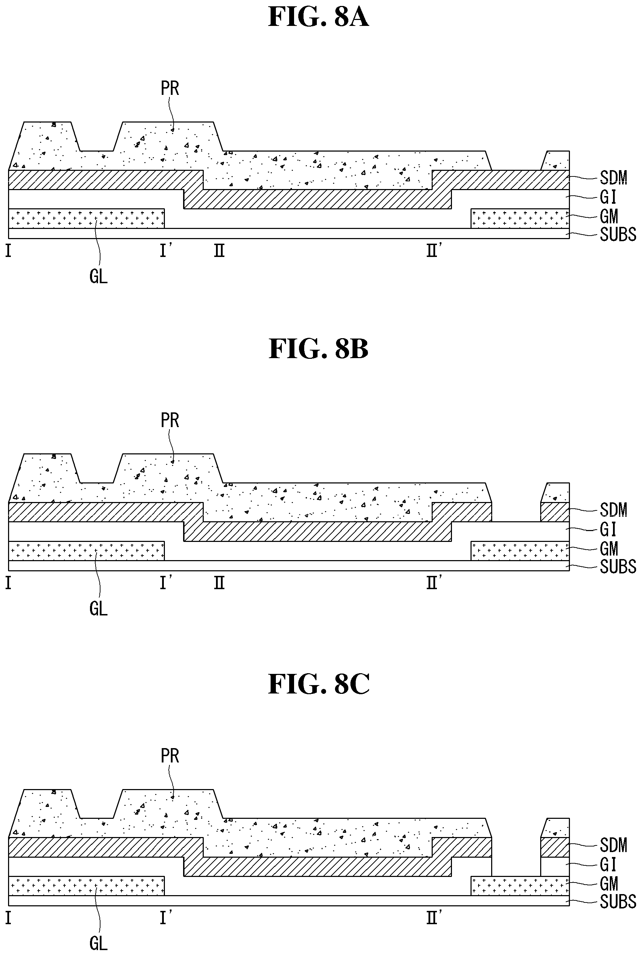

Referring to FIGS. 3A and 3B, the source-drain metal is deposited on the gate insulator GI, and the second photomask process is performed to form a source-drain metal pattern and etch the gate insulator GI. As shown in FIGS. 8A to 8E, the second photomask process forms a photoresist pattern having a height difference of 2 steps using a halftone mask and thus can etch the source-drain metal and the gate insulator GI using one photomask without replacing a photomask. The second photomask process wet-etches the gate insulator GI and exposes the contact electrode GM. Then, the second photomask process ashes a photoresist pattern, etches the source-drain metal covering the channel region of the TFT, and exposes the gate insulator GI in the channel region of the TFT. The source-drain metal may be formed of copper (Cu). Other materials may be used for the source-drain metal. The source-drain metal pattern includes the data line DL, the source S of the TFT, and the like. A drain of the TFT may be integrated with the data line DL.

The embodiment of the invention forms the oxide semiconductor after forming the source-drain metal pattern, so as to prevent the oxide semiconductor from being melted and lost when the gate insulator GI or the source-drain metal pattern (DL, S) is wet etched.

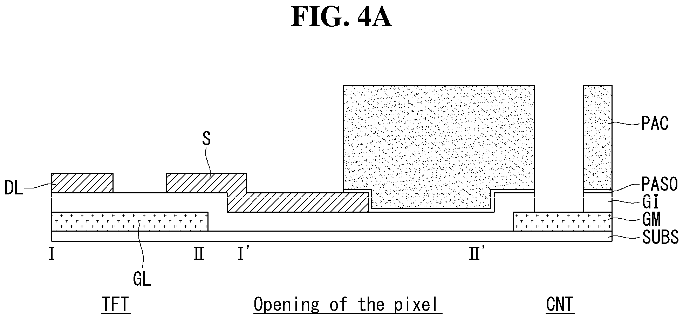

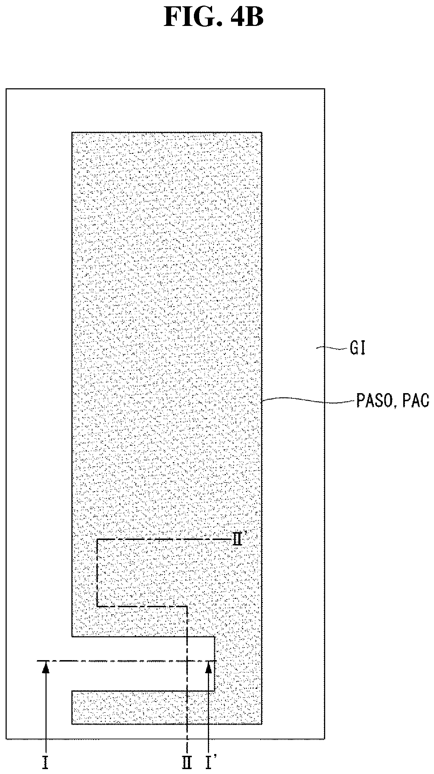

A third photomask process is described with reference to FIGS. 4A and 4B.

Referring to FIGS. 4A and 4B, the embodiment of the invention successively deposits a first inorganic passivation layer PASO and an organic passivation layer PAC on a portion of the source-drain metal pattern and the gate insulator GI. The embodiment of the invention performs the third photomask process to partially etch the first inorganic passivation layer PASO and the organic passivation layer PAC and to form a passivation layer pattern. The passivation layer pattern is disposed only in an opening excluding the TFT from the pixel, so that the TFT is exposed inside the pixel. The first inorganic passivation layer PASO may be formed of silicon oxide (SiOx). The organic passivation layer PAC may be formed of photoacryl. The third photomask process aligns a photomask on the organic passivation layer PAC and sequentially performs an exposure process, a development process, and a dry etching process, thereby etching the first inorganic passivation layer PASO and the organic passivation layer PAC. As a result, the passivation layer pattern, in which the first inorganic passivation layer PASO and the organic passivation layer PAC are stacked, remains only in the opening of the pixel except the TFT and a peripheral area of the TFT.

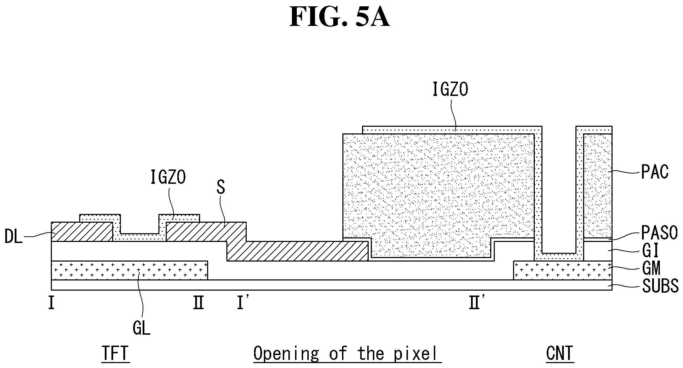

A fourth photomask process is described with reference to FIGS. 5A to 5C.

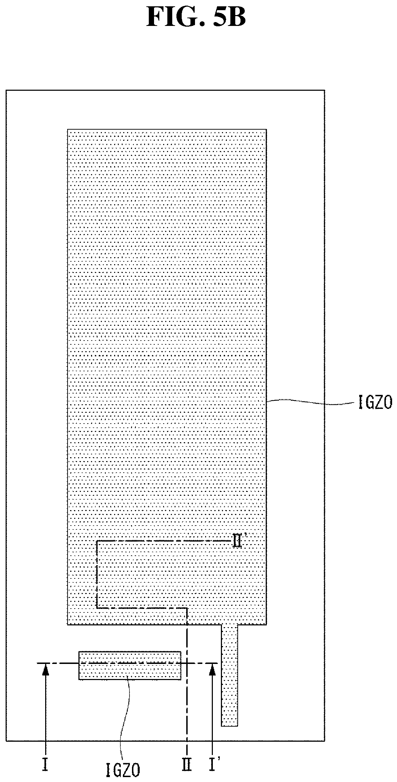

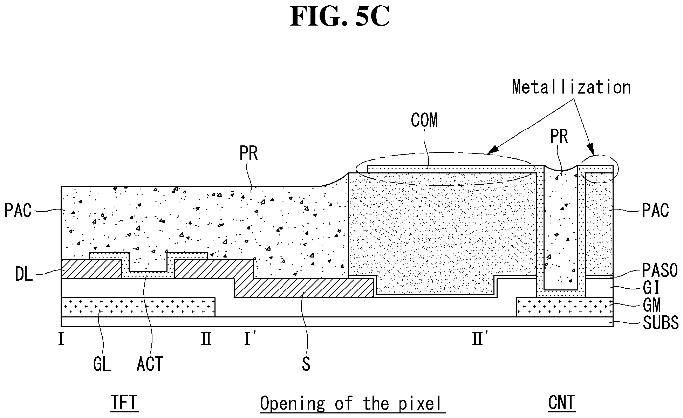

Referring to FIGS. 5A and 5B, the embodiment of the invention deposits the oxide semiconductor on the entire surface of the substrate SUBS and performs the fourth photomask process to partially etch the oxide semiconductor and to form an oxide semiconductor pattern ACT (refer to FIG. 5C). The oxide semiconductor may be selected as Indium-Gallium-Zinc Oxide (IGZO). Other materials may be used. The oxide semiconductor pattern ACT includes a first oxide semiconductor pattern, which is formed in the channel region between the source S and the drain of the TFT so as to contact the source S and the drain of the TFT, and a second oxide semiconductor pattern formed in the opening of the pixel. The first oxide semiconductor pattern formed in the channel region of the TFT directly contacts the data line DL and the drain and the source S of the TFT. The oxide semiconductor (IGZO) is a nonconductor having a high resistance. However, the oxide semiconductor (IGZO) is changed to the oxide semiconductor pattern ACT of the TFT and the common electrode COM of the pixel through a plasma processing and a thermal process, which will be described later.

Conductive characteristics of the oxide semiconductor (IGZO) vary depending on a content of oxygen. In the embodiment of the invention, the same metal oxide semiconductor material as Indium-Gallium-Zinc Oxide (IGZO) used in a semiconductor layer SEM has characteristics of a conductor or a nonconductor by properly adjusting a content of oxygen. When the content of oxygen decreases, the metal oxide semiconductor material has the characteristics of the conductor because the metal properties increase. The plasma processing may be used to decrease the content of oxygen. Namely, the plasma processing is performed on the oxide semiconductor to remove oxygen contained in the oxide semiconductor. Hence, a resistance of the oxide semiconductor is reduced, and the oxide semiconductor may be metalized. The plasma processing is a method for generating a plasma discharge in helium (He) gas, hydrogen (H₂) gas, or argon (Ar) gas. The metallization of the oxide semiconductor is performed in a contact hole filling (CHF) process and a fifth photomask process. The metallization of the oxide semiconductor may be performed in the contact hole filling (CHF) process and the fifth photomask process, or may be subsequently performed.

The contact hole filling (CHF) process applies a photoresist PR on the substrate SUBS, ashes the photoresist PR, and fills the photoresist PR only in holes passing through the passivation layer pattern. As the result of the contact hole filling (CHF) process, as shown in FIG. 5C, the oxide semiconductor pattern ACT formed on the TFT and the oxide semiconductor pattern ACT formed on the contact electrode GM are covered by the photoresist PR. Subsequently, the substrate SUBS is exposed through the plasma processing in a state where the photoresist PR remains only in the holes. As a result, as shown in FIG. 5C, the oxide semiconductor pattern ACT exposed on the passivation layer pattern is metalized. A metalized portion of the oxide semiconductor pattern ACT serves as the common electrode COM, to which the common voltage Vcom is supplied through the contact electrode GM. Thus, the contact hole filling (CHF) process is a process for selectively metalizing the oxide semiconductor without the photomask process.

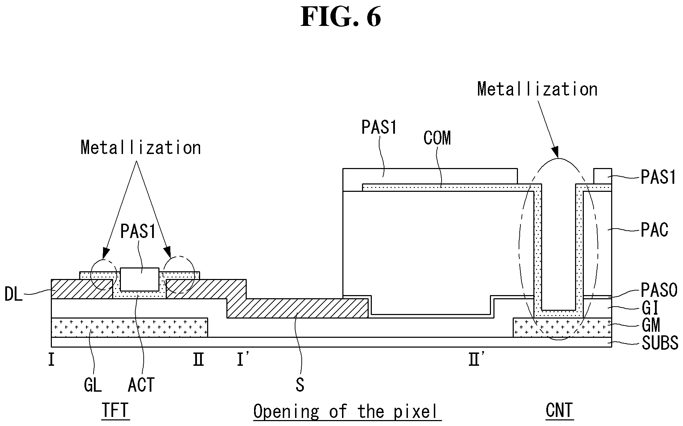

A fifth photomask process is described with reference to FIG. 6.

Referring to FIG. 6, the embodiment of the invention deposits an inorganic insulator on the substrate SUBS and performs the fifth photomask process to partially etch the inorganic insulator. A second inorganic insulator PAS1 covers the common electrode COM on the passivation layer pattern (PAC, PASO) and covers the channel region of the TFT. The oxide semiconductor in source and drain contact areas excluding the channel region from the TFT and the oxide semiconductor formed in a contact hole on the contact electrode GM are exposed. The embodiment of the invention performs second plasma processing to metalize the exposed oxide semiconductor. As a result, the common electrode COM and the contact electrode GM are connected to a conductor with a low resistance. The source and drain contact areas of the TFT are metalized, and the source and the drain of the TFT and an ohmic contact may be formed. Because the channel region of the TFT is protected by an inorganic insulator pattern serving as the etch stopper, the channel region is not metalized. The source S of the TFT directly contacts the metalized oxide semiconductor pattern. The drain of the TFT includes the metalized oxide semiconductor pattern, and the metalized oxide semiconductor pattern directly contacts the data line DL. Thus, the source and the drain of the TFT include the metalized oxide semiconductor pattern. The oxide semiconductor pattern ACT of the channel region of the TFT covered by the second inorganic insulator PAS 1 is an active layer forming a channel of the TFT by adjusting an oxygen concentration of the oxide semiconductor pattern ACT through the thermal process.

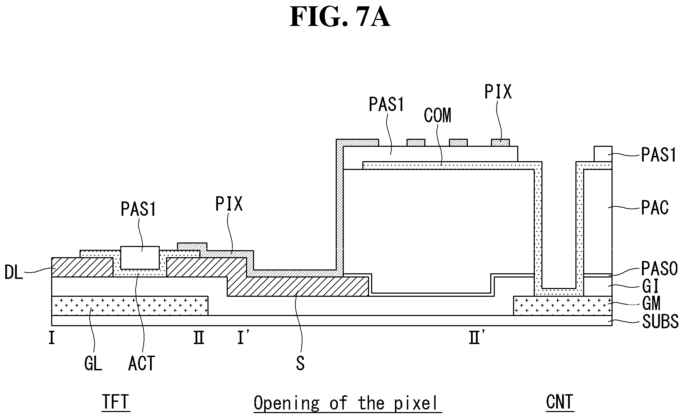

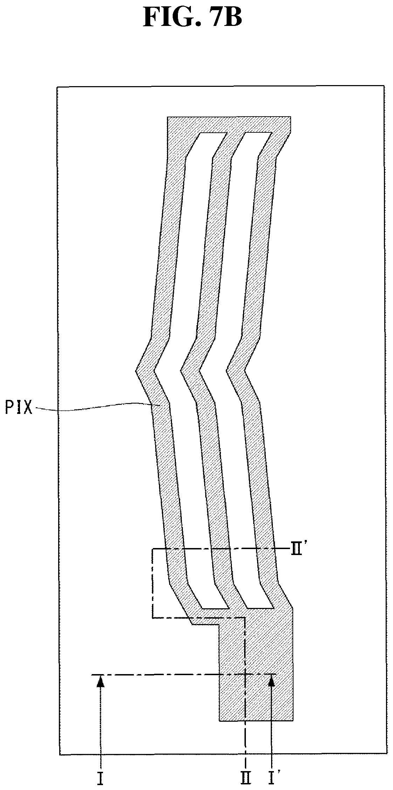

A sixth photomask process is described with reference to FIGS. 7A and 7B.

Referring to FIGS. 7A and 7B, the embodiment of the invention deposits a transparent electrode material on the substrate SUBS and performs the sixth photomask process to partially etch the transparent electrode material. Hence, the pixel electrode PIX is formed. The transparent electrode material may be selected as indium tin oxide (ITO). The pixel electrode PIX is connected to the source S of the TFT and is formed in the opening of the pixel, thereby forming an electric field along with the common electrode COM. In the opening of the pixel, the pixel electrode PIX overlaps the common electrode COM with the second inorganic insulator PAS1 interposed therebetween. The pixel electrode PIX directly contacts the source S of the TFT. A contact portion between the pixel electrode PIX and the source S of the TFT overlaps the gate line GL, and thus the aperture ratio of the pixel is not reduced.

When a separate third metal is formed on the source-drain metal pattern and under the pixel electrode PIX, a photomask process for partially etching the third metal may be added before the sixth photomask process.

FIGS. 8A to 8E are cross-sectional views showing in stages the second photomask process.

As shown in FIG. 8A, the second photomask process successively deposits the gate insulator GI and a source-drain metal SDM on the substrate SUBS and applies the photoresist PR on the source-drain metal SDM. Subsequently, as shown in FIG. 8B, the second photomask process aligns the halftone mask on the photoresist PR and then exposes the photoresist PR through the halftone mask, thereby develops the photoresist PR. As a result, the photoresist PR on the contact electrode GM is removed, and the photoresist PR of a thin thickness remains in the channel region of the TFT. Further, the photoresist PR of a thick thickness remains in other portions. Subsequently, as shown in FIG. 8C, the second photomask process performs the wet etching process to remove the gate insulator GI and expose the contact electrode GM.

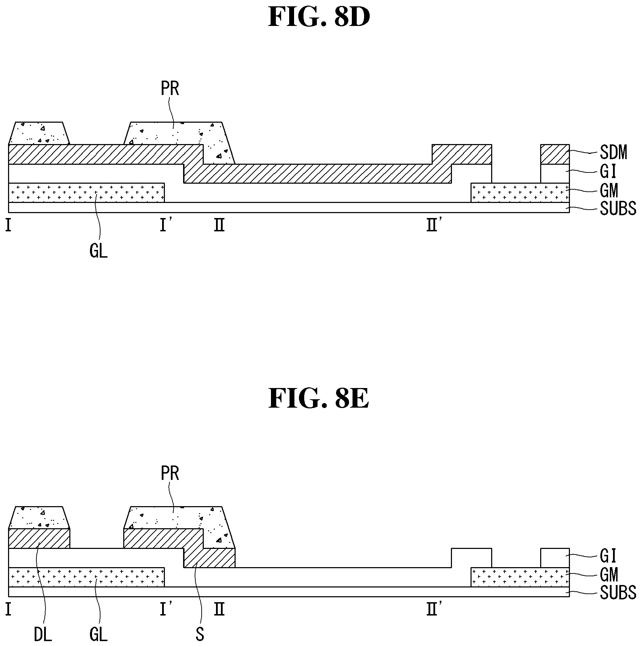

Subsequently, as shown in FIG. 8D, the second photomask process ashes the photoresist PR to reduce a height of the photoresist PR and expose the source-drain metal SDM in the channel region of the TFT. Subsequently, as shown in FIG. 8E, the second photomask process performs the wet etching process to etch the source-drain metal SDM.

FIG. 9 shows an improvement effect of the aperture ratio of the display device according to the embodiment of the invention.

Referring to FIG. 9, a related art pixel shown at the left side of FIG. 9 is a comparative example where the source of the TFT and the pixel electrode contact each other through a contact hole passing through inorganic passivation layers and an organic passivation layer. In the related art pixel, because the size of the contact hole contacting the source of the TFT and the pixel electrode is large, the size of an opening of the related art pixel is small. On the contrary, in the pixel according to the embodiment of the invention shown at the right side of FIG. 9, the source of the TFT and the pixel electrode PXL directly contact each other in a portion not having the passivation layer, and a contact portion between the source of the TFT and the pixel electrode PXL is positioned on the gate line GL. Thus, the size of the opening of the pixel according to the embodiment of the invention can increase compared to the related art pixel.

A position of the pixel electrode PXL and a position of the common electrode COM may be reversed. In this instance, the common electrode COM is positioned on the pixel electrode PXL.

The display device according to the embodiment of the invention may be applied to any display device, in which the TFT is formed at each pixel. For example, a TFT array substrate according to the embodiment of the invention may be applied to a liquid crystal display of an in-plane switching (IPS) mode or a fringe field switching (FFS) mode. Further, in the display device according to the embodiment of the invention, if the pixel electrode PXL is connected to an anode of an organic light emitting diode (OLED), the pixel electrode PXL may be applied to an OLED display.

As described above, the embodiment of the invention patterns the source-drain metal and the gate insulator in one photomask process, simultaneously forms the oxide semiconductor pattern of the TFT and the common electrode, and simultaneously forms the inorganic passivation layer and the etch stopper, thereby reducing the number of manufacturing processes. Further, the embodiment of the invention directly contacts the source of the TFT and the pixel electrode on the gate line or the gate of the TFT, thereby increasing the aperture ratio.

Although embodiments have been described with reference to a number of illustrative embodiments thereof, it should be understood that numerous other modifications and embodiments can be devised by those skilled in the art. In addition to variations and modifications in the component parts and/or arrangements, alternative uses will also be apparent to those skilled in the art.

## Claims

1. A display device comprising:
a thin film transistor (TFT) including a gate connected to a gate line (GL), a drain connected to a data line (DL), and a source (S) connected to a pixel electrode (PIX); and
a passivation layer pattern (PAC; PASO) formed in an opening of a pixel, except the thin film transistor (TFT) and a peripheral area of the thin film transistor (TFT), wherein the pixel electrode (PIX) directly contacts the source (S) of the thin film transistor (TFT)on the gate of the thin film transistor (TFT)or the gate line (GL);
further comprising:
a contact electrode (GM), configured to be supplied with a common voltage;
a first oxide semiconductor pattern (ACT) disposed in a channel region of the thin film transistor (TFT), the first oxide semiconductor pattern (ACT) configured to contact the data line (DL) and the source (S) and the drain of the thin film transistor (TFT);
a second oxide semiconductor pattern (COM) configured to contact the contact electrode (GM); and
an insulator (PAS1) including an insulating pattern covering a portion of the first oxide semiconductor pattern (ACT) and an insulating pattern covering a portion of the second oxide semiconductor pattern (COM);
wherein the pixel electrode (PIX) overlaps the second oxide semiconductor pattern (COM) on the insulator (PAS1);
wherein a portion of the first oxide semiconductor pattern (ACT) not covered by the insulator (PAS1) is metallized and
so has a sheet resistance lower than the portion of the first oxide semiconductor pattern (ACT) covered by the insulator (PAS1), wherein the metallized portion of the first oxide semiconductor pattern (ACT) serves as a source contact area and a drain contact area of the thin film transistor (TFT), and
wherein a portion of the second oxide semiconductor pattern (COM) not covered by the insulator (PAS1) is metallized and so has a sheet resistance lower than the portion of the second oxide semiconductor pattern (COM) covered by the insulator (PAS1), wherein the metallized portion of the second oxide semiconductor pattern (COM) serves as a common electrode of the display device.

2. The display device of claim 1,
wherein the contact electrode (GM) is formed on the same level layer as the gate of the thin film transistor (TFT) and connected to the common electrode (COM), and
wherein the common electrode (COM) includes a metalized portion of the second oxide semiconductor pattern and contacts the contact electrode (GM) through a contact hole passing through the passivation layer pattern (PAC; PASO).

3. The display device of claim 1,
wherein the portion of the first oxide semiconductor pattern (ACT) not covered by the insulator contacts the data line (DL) and the drain of the thin film transistor (TFT), and wherein the portion of the second oxide semiconductor pattern (COM) not covered by the insulator (PAS1) contacts the contact electrode (GM).

4. The display device of claim 1, further comprising:
a first metal pattern including the gate line (GL), the gate of the thin film transistor (TFT) connected to the gate line (GL), and the contact electrode (GM);
a gate insulator (GI) configured to cover the gate of the thin film transistor (TFT) and the gate line (GL) and to expose the contact electrode (GM);
a second metal pattern including the data line (DL), the drain of the thin film transistor (TFT) connected to the data line (DL), and the source (S) of the thin film transistor (TFT), the second metal pattern disposed on the gate insulator (GI);
a first inorganic passivation layer (PASO) disposed on a portion of the second metal pattern and the gate insulator (GI); and
an organic passivation layer (PAC) disposed on the first inorganic passivation layer (PASO);
wherein the insulator (PAS1) is a second inorganic insulator (PAS1), and wherein the passivation layer pattern (PAC; PASO) includes the first inorganic passivation layer (PASO) and the organic passivation layer (PAC).

5. The display device of claim 4, wherein the portion of the first oxide semiconductor pattern (ACT) not covered by the second inorganic insulator (PAS1) contacts the data line (DL) and the drain of the thin film transistor (TFT), and
wherein the portion of the second oxide semiconductor pattern (COM) not covered by the second inorganic insulator (PAS1) contacts the contact electrode (GM) and receives a common voltage through the contact electrode (GM).

6. A method for manufacturing a display device comprising:
forming a gate line (GL), a gate of a thin film transistor (TFT), and a contact electrode (GM) on a substrate (SUBS) and forming a gate insulator (GI) covering the gate line (GL), the gate of the thin film transistor (TFT), and the contact electrode (GM) on the substrate (SUBS);
forming a data line (DL), a source (S) of the thin film transistor (TFT), and a drain of the thin film transistor (TFT) on the gate insulator (GI);
**characterized by**
exposing the contact electrode (GM) and the gate insulator (GI) in a channel region between the source (S) and the drain of the thin film transistor (TFT);
forming a passivation layer pattern (PAC; PASO), in which an inorganic passivation layer (PAS0) and an organic passivation layer (PAC) are stacked, in an opening of a pixel, except the thin film transistor (TFT) and a peripheral area of the thin film transistor (TFT);
forming an oxide semiconductor pattern (IGZO) in a channel region and a source-drain area of the thin film transistor (TFT) and the opening of the pixel, covering the thin film transistor (TFT) and the contact electrode (GM) with a photoresist (PR), performing a plasma processing on the exposed oxide semiconductor pattern to metalize the oxide semiconductor pattern, and forming a common electrode (COM), wherein the metallized portion of the oxide semiconductor pattern serves as the common electrode (COM) of the display device;
forming an insulator (PAS1) covering the oxide semiconductor pattern (ACT) in the channel region of the thin film transistor (TFT) and the common electrode (COM) and performing a second plasma processing to metalize an oxide semiconductor pattern (ACT) formed in the source-drain area of the thin film transistor (TFT) and an oxide semiconductor pattern between the common electrode (COM) and the contact electrode (GM), wherein the metallized portion of the oxide semiconductor pattern (ACT) serves as a source contact area and a drain contact area of the thin film transistor (TFT); and
forming a pixel electrode (PIX) directly contacting the source (S) of the thin film transistor (TFT) on the gate of the thin film transistor (TFT) or the gate line (GL), wherein the pixel electrode (PIX) overlaps the second oxide semiconductor pattern (COM) on the insulator (PAS1).

## Patentansprüche

1. Anzeigevorrichtung, umfassend:
einen Dünnschichttransistor (TFT), der ein Gate, das mit einer Gateleitung (GL) verbunden ist, ein Drain, das mit einer Datenleitung (DL) verbunden ist, und ein Source (S), das mit einer Pixelelektrode (PIX) verbunden ist, beinhaltet; und
ein Passivierungsschichtmuster (PAC; PASO), das in einer Öffnung eines Pixels ausgebildet ist, mit Ausnahme des Dünnschichttransistors (TFT) und eines Randbereichs des Dünnschichttransistors (TFT), wobei die Pixelelektrode (PIX) das Source (S) des Dünnschichttransistors (TFT) auf dem Gate des Dünnschichttransistors (TFT) oder der Gateleitung (GL) direkt berührt;
ferner umfassend:
eine Kontaktelektrode (GM), die konfiguriert ist, um mit einer gemeinsamen Spannung versorgt zu werden;
ein erstes Oxid-Halbleitermuster (ACT), das in einem Kanalbereich des Dünnschichttransistors (TFT) angeordnet ist, wobei das erste Oxid-Halbleitermuster (ACT) konfiguriert ist, um die Datenleitung (DL) und das Source (S) und das Drain des Dünnschichttransistors (TFT) zu berühren;
ein zweites Oxid-Halbleitermuster (COM), das konfiguriert ist, um die Kontaktelektrode (GM) zu berühren; und
einen Isolator (PAS1), der ein Isoliermuster, das einen Abschnitt des ersten Oxid-Halbleitermusters (ACT) bedeckt, und ein Isoliermuster, das einen Abschnitt des zweiten Oxid-Halbleitermusters (COM) bedeckt, beinhaltet;
wobei die Pixelelektrode (PIX) das zweite Oxid-Halbleitermuster (COM) auf dem Isolator (PAS1) überlappt;
wobei ein Abschnitt des ersten Oxid-Halbleitermusters (ACT), der nicht von dem Isolator (PAS1) bedeckt ist, metallisiert ist und somit einen Schichtwiderstand aufweist, der geringer ist als der Abschnitt des ersten Oxid-Halbleitermusters (ACT), der von dem Isolator (PAS1) bedeckt ist, wobei der metallisierte Abschnitt des ersten Oxid-Halbleitermusters (ACT) als Source-Kontaktbereich und Drain-Kontaktbereich des Dünnschichttransistors (TFT) dient und
wobei ein Abschnitt des zweiten Oxid-Halbleitermusters (COM), der nicht von dem Isolator (PAS1) bedeckt ist, metallisiert ist und somit einen Schichtwiderstand aufweist, der geringer ist als der Abschnitt des zweiten Oxid-Halbleitermusters (COM), der von dem Isolator (PAS1) bedeckt ist, wobei der metallisierte Abschnitt des zweiten Oxid-Halbleitermusters (COM) als gemeinsame Elektrode der Anzeigevorrichtung dient.

2. Anzeigevorrichtung nach Anspruch 1, wobei die Kontaktelektrode (GM) auf der gleichen Ebenenschicht wie das Gate des Dünnschichttransistors (TFT) ausgebildet und mit der gemeinsamen Elektrode (COM) verbunden ist und
wobei die gemeinsame Elektrode (COM) einen metallisierten Abschnitt des zweiten Oxid-Halbleitermusters beinhaltet und die Kontaktelektrode (GM) durch ein Kontaktloch berührt, das durch das Passivierungsschichtmuster (PAC; PASO) verläuft.

3. Anzeigevorrichtung nach Anspruch 1, wobei der Abschnitt des ersten Oxid-Halbleitermusters (ACT), der nicht von dem Isolator bedeckt ist, die Datenleitung (DL) und das Drain des Dünnschichttransistors (TFT) berührt und
wobei der Abschnitt des zweiten Oxid-Halbleitermusters (COM), der nicht von dem Isolator (PAS1) bedeckt ist, die Kontaktelektrode (GM) berührt.

4. Anzeigevorrichtung nach Anspruch 1, ferner umfassend:
ein erstes Metallmuster, das die Gateleitung (GL), das Gate des Dünnschichttransistors (TFT), das mit der Gateleitung (GL) verbunden ist, und die Kontaktelektrode (GM) beinhaltet;
einen Gate-Isolator (GI), der konfiguriert ist, um das Gate des Dünnschichttransistors (TFT) und die Gateleitung (GL) zu bedecken und die Kontaktelektrode (GM) freizuhalten;
ein zweites Metallmuster, das die Datenleitung (DL), das Drain des Dünnschichttransistors (TFT), das mit der Datenleitung (DL) verbunden ist, und das Source (S) des Dünnschichttransistors (TFT) beinhaltet, wobei das zweite Metallmuster auf dem Gate-Isolator (GI) angeordnet ist;
eine erste anorganische Passivierungsschicht (PAS0), die auf einem Abschnitt des zweiten Metallmusters und des Gate-Isolators (GI) angeordnet ist; und
eine organische Passivierungsschicht (PAC), die auf der ersten anorganischen Passivierungsschicht (PAS0) angeordnet ist;
wobei der Isolator (PAS1) ein zweiter anorganischer Isolator (PAS1) ist und wobei das Passivierungsschichtmuster (PAC; PASO) die erste anorganische Passivierungsschicht (PAS0) und die organische Passivierungsschicht (PAC) beinhaltet.

5. Anzeigevorrichtung nach Anspruch 4, wobei der Abschnitt des ersten Oxid-Halbleitermusters (ACT), der nicht von dem zweiten anorganischen (PAS1) Isolator bedeckt ist, die Datenleitung (DL) und das Drain des Dünnschichttransistors (TFT) berührt und
wobei der Abschnitt des zweiten Oxid-Halbleitermusters (COM), der nicht von dem zweiten anorganischen (PAS1) Isolator bedeckt ist, die Kontakelektrode (GM) berührt und eine gemeinsame Spannung durch die Kontaktelektrode (GM) aufnimmt.

6. Verfahren zum Fertigen einer Anzeigevorrichtung, umfassend:
Bilden einer Gateleitung (GL), eines Gates eines Dünnschichttransistors (TFT) und einer Kontaktelektrode (GM) auf einem Substrat (SUBS) und Bilden eines Gate-Isolators (GI), der die Gateleitung (GL), das Gate des Dünnschichttransistors (TFT) und die Kontaktelektrode (GM) bedeckt, auf dem Substrat (SUBS);
Bilden einer Datenleitung (DL), eines Source (S) des Dünnschichttransistors (TFT) und eines Drains des Dünnschichttransistors (TFT) auf dem Gate-Isolator (GI);
**gekennzeichnet durch**
Freihalten der Kontaktelektrode (GM) und des Gate-Isolators (GI) in einem Kanalbereich zwischen dem Source (S) und dem Drain des Dünnschichttransistors (TFT);
Bilden eines Passivierungsschichtmusters (PAC; PASO), in dem eine anorganische Passivierungsschicht (PAS0) und eine organische Passivierungsschicht (PAC) gestapelt sind, in einer Öffnung eines Pixels, mit Ausnahme des Dünnschichttransistors (TFT) und eines Randbereichs des Dünnschichttransistors (TFT);
Bilden eines Oxid-Halbleitermusters (IGZO) in einem Kanalbereich und einem Source-Drain-Bereich des Dünnschichttransistors (TFT) und der Öffnung des Pixels, das den Dünnschichttransistor (TFT) und die Kontaktelektrode (GM) mit einem Fotoresist (PR) bedeckt, Durchführen einer Plasmaverarbeitung auf dem freiliegenden Oxid-Halbleitermuster, um das Oxid-Halbleitermuster zu metallisieren, und Bilden einer gemeinsamen Elektrode (COM), wobei der metallisierte Abschnitt des Oxid-Halbleitermusters als gemeinsame Elektrode (COM) der Anzeigevorrichtung dient;
Bilden eines Isolators (PAS1), der das Oxid-Halbleitermuster (ACT) in dem Kanalbereich des Dünnschichttransistors (TFT) und der gemeinsamen Elektrode (COM) bedeckt und Durchführen einer zweiten Plasmaverarbeitung, um ein Oxid-Halbleitermuster (ACT), das in dem Source-Drain-Bereich des Dünnschichttransistors (TFT) gebildet ist, und ein Oxid-Halbleitermuster zwischen der gemeinsamen Elektrode (COM) und der Kontaktelektrode (GM) zu metallisieren, wobei der metallisierte Abschnitt des Oxid-Halbleitermusters (ACT) als Source-Kontaktbereich und Drain-Kontaktbereich des Dünnschichttransistors (TFT) dient, und
Bilden einer Pixelelektrode (PIX), die das Source (S) des Dünnschichttransistors (TFT) auf dem Gate des Dünnschichttransistors (TFT) oder die Gateleitung (GL) direkt berührt, wobei die Pixelelektrode (PIX) das zweite Oxid-Halbleitermuster (COM) auf dem Isolator (PAS1) überlappt.

## Revendications

1. Dispositif d'affichage comportant :
un transistor à couches minces (TFT) incluant une grille connectée à une ligne de grille (GL), un drain connecté à une ligne de données (DL), et une source (S) connectée à une électrode de pixel (PIX) ; et
un motif de couche de passivation (PAC ; PASO) formé dans une ouverture d'un pixel, à l'exception du transistor à couches minces (TFT) et d'une zone périphérique du transistor à couches minces (TFT), dans lequel l'électrode de pixel (PIX) vient directement en contact avec la source (S) du transistor à couches minces (TFT) sur la grille du transistor à couches minces (TFT) ou la ligne de grille (GL) ;
comportant en outre :
une électrode de contact (GM), configurée pour être alimentée par une tension commune ;
un premier motif de semi-conducteur à oxyde (ACT) disposé dans une zone de canal du transistor à couches minces (TFT), le motif de semi-conducteur à oxyde (ACT) étant configuré pour venir en contact avec la ligne de données (DL) et la source (S) et le drain du transistor à couches minces (TFT) ;
un second motif de semi-conducteur à oxyde (COM) configuré pour venir en contact avec l'électrode de contact (GM) ; et
un isolant (PAS1) incluant un motif d'isolation recouvrant une partie du premier motif de semi-conducteur à oxyde (ACT) et un motif d'isolation recouvrant une partie du second motif de semi-conducteur à oxyde (COM) ;
dans lequel l'électrode de pixel (PIX) chevauche le second motif de semi-conducteur à oxyde (COM) sur l'isolant (PAS1) ;
dans lequel une partie du premier motif de semi-conducteur à oxyde (ACT) non recouverte par l'isolant (PAS1) est métallisée et a ainsi une résistance de couche inférieure à la partie du premier motif de semi-conducteur à oxyde (ACT) recouverte par l'isolant (PAS1), dans lequel la partie métallisée du premier motif de semi-conducteur à oxyde (ACT) sert de surface de contact de source et de surface de contact de drain du transistor à couches minces (TFT), et
dans lequel une partie du second motif de semi-conducteur à oxyde (COM) non recouverte par l'isolant (PAS1) est métallisée et a ainsi une résistance de couche inférieure à la partie du second motif de semi-conducteur à oxyde (COM) recouverte par l'isolant (PAS1), dans lequel la partie métallisée du second motif de semi-conducteur à oxyde (COM) sert d'électrode commune du dispositif d'affichage.

2. Dispositif d'affichage selon la revendication 1, dans lequel l'électrode de contact (GM) est formée sur la même couche de niveau que la grille du transistor à couches minces (TFT) et connectée à l'électrode commune (COM), et
dans lequel l'électrode commune (COM) inclut une partie métallisée du second motif de semi-conducteur à oxyde et vient en contact avec l'électrode de contact (GM) à travers un trou de contact passant à travers le motif de couche de passivation (PAC ; PASO).

3. Dispositif d'affichage selon la revendication 1, dans lequel la partie du premier motif de semi-conducteur à oxyde (ACT) non recouverte par l'isolant vient en contact avec la ligne de données (DL) et le drain du transistor à couches minces (TFT), et
dans lequel la partie du second motif de semi-conducteur à oxyde (COM) non recouverte par l'isolant (PAS1) vient en contact avec l'électrode de contact (GM).

4. Dispositif d'affichage selon la revendication 1, comportant en outre :
un premier motif métallique incluant la ligne de grille (GL), la grille du transistor à couches minces (TFT) connectée à la ligne de grille (GL), et l'électrode de contact (GM) ;
un isolant de grille (GI) configuré pour recouvrir la grille du transistor à couches minces (TFT) et la ligne de grille (GL) et pour exposer l'électrode de contact (GM) ;
un second motif métallique incluant la ligne de données (DL), le drain du transistor à couches minces (TFT) connecté à la ligne de données (DL), et la source (S) du transistor à couches minces (TFT), le second motif métallique étant disposé sur l'isolant de grille (GI) ;
une première couche de passivation inorganique (PAS0) disposée sur une partie du second motif métallique et l'isolant de grille (GI) ; et
une couche de passivation organique (PAC) disposée sur la première couche de passivation inorganique (PAS0) ;
dans lequel l'isolant (PAS1) est un second isolant inorganique (PAS1), et dans lequel le motif de couche de passivation (PAC ; PASO) inclut la première couche de passivation inorganique (PAS0) et la couche de passivation organique (PAC).

5. Dispositif d'affichage selon la revendication 4, dans lequel la partie du premier motif de semi-conducteur à oxyde (ACT) non recouverte par le second isolant inorganique (PAS1) vient en contact avec la ligne de données (DL) et le drain du transistor à couches minces (TFT), et
dans lequel la partie du second motif de semi-conducteur à oxyde (COM) non recouverte par le second isolant inorganique (PAS1) vient en contact avec l'électrode de contact (GM) et reçoit une tension commune via l'électrode de contact (GM).

6. Procédé pour fabriquer un dispositif d'affichage comportant les étapes consistant à :
former une ligne de grille (GL), une grille d'un transistor à couches minces (TFT) et une électrode de contact (GM) sur un substrat (SUBS) et former un isolant de grille (GI) recouvrant la ligne de grille (GL), la grille du transistor à couches minces (TFT) et l'électrode de contact (GM) sur le substrat (SUBS) ;
former une ligne de données (DL), une source (S) du transistor à couches minces (TFT) et un drain du transistor à couches minces (TFT) sur l'isolant de grille (GI) ;
**caractérisé par** les étapes consistant à :
exposer l'électrode de contact (GM) et l'isolant de grille (GI) dans une zone de canal entre la source (S) et le drain du transistor à couches minces (TFT) ;
former un motif de couche de passivation (PAC ; PASO), dans lequel une couche de passivation inorganique (PAS0) et une couche de passivation organique (PAC) sont empilées, dans une ouverture d'un pixel, à l'exception du transistor à couches minces (TFT) et d'une zone périphérique du transistor à couches minces (TFT) ;
former un motif de semi-conducteur à oxyde (IGZO) dans une zone de canal et une zone de source-drain du transistor à couches minces (TFT) et l'ouverture du pixel, recouvrant le transistor à couches minces (TFT) et l'électrode de contact (GM) avec une photorésine (PR), réaliser un traitement au plasma sur le motif de semi-conducteur à oxyde exposé pour métalliser le motif de semi-conducteur à oxyde, et former une électrode commune (COM), dans lequel la partie métallisée du motif de semi-conducteur à oxyde sert d'électrode commune (COM) du dispositif d'affichage ;
former un isolant (PAS1) recouvrant le motif de semi-conducteur à oxyde (ACT) dans la zone de canal du transistor à couches minces (TFT) et l'électrode commune (COM) et réaliser un second traitement au plasma pour métalliser un motif de semi-conducteur à oxyde (ACT) formé dans la zone de source-drain du transistor à couches minces (TFT) et un motif de semi-conducteur à oxyde entre l'électrode commune (COM) et l'électrode de contact (GM), dans lequel la partie métallisée du motif de semi-conducteur à oxyde (ACT) sert de surface de contact de source et de surface de contact de drain du transistor à couches minces (TFT) ; et
former une électrode de pixel (PIX) venant directement en contact avec la source (S) du transistor à couches minces (TFT) sur la grille du transistor à couches minces (TFT) ou la ligne de grille (GL), dans lequel l'électrode de pixel (PIX) chevauche le second motif de semi-conducteur à oxyde (COM) sur l'isolant (PAS1).
